# EUROPEAN PATENT APPLICATION

(11) **EP 2 510 996 A1**
(43) Date of publication of application: **17.10.2012**
(21) Application number: 12155727.6
(22) Date of filing: 16.02.2012
(51) Int. Cl.: B01D 46/22, B01D 46/00

(54) **Protective filter**

(30) Priority: 11.04.2011 JP 2011087547
(71) Applicant: Teoss CO., LTD., Tokyo 185-0012 (JP)
(72) Inventor: Murai, Tsuyoshi, Tokyo, 185-0012 (JP); Konaka, Toshinori, Tokyo, 185-0012 (JP)
(74) Representative: Mounteney, Simon James

(57) **Abstract**

The protecting filter (10) comprises: a casing (12) having an inner space (19); an exhaust gas intake pipe (14) guiding exhaust gas (H) with microparticles; a rotating body (16) supported rotatably on the centre axis of the exhaust gas intake pipe (14) and at an opening of the exhaust gas intake pipe (14) inside the casing (12); and an endless belt (18) provided rotatably inside the casing (12) and facing the opening of the exhaust gas intake pipe (14) across the rotating body (16) and including microparticle collection liquid (L) at least on its surface, wherein the surface of the endless belt (18) contacts the rotating body (16), the rotating body (16) is rotated by rotation of the endless belt (18), the microparticle collection liquid (L) on the surface of the endless belt (18) is applied to a surface of the rotating body (16).

## Description

### Background of the Invention

### Field of the Invention

The present invention relates to a protective filter removing microparticles contained in exhaust gas from upstream manufacturing equipment using vacuum or reduced pressure (hereinafter, both of them are called "reducedpressure"). The microparticles are SiO microparticles, a-Si microparticles (amorphous silicon microparticles), microparticles of reactionproducts, or the like from semi conductor production equipment, for example single crystal lifting equipment and CVD (Chemical Vapor Deposition) equipment. And the protective filter supplies powder-free exhaust gas to a downstream vacuum pump.

### Description of Related Art

The manufacturing equipment using reduced pressure is operated in reduced pressure atmosphere, flowing inert gas. The manufacturing equipment requires a downstream vacuum pump. The vacuum pump suctions continuously the exhaust gas generated inside the manufacturing equipment in operation. When the exhaust gas includes the microparticles, the microparticles are accumulated gradually inside the vacuum pump, with breakage of the vacuum pump.

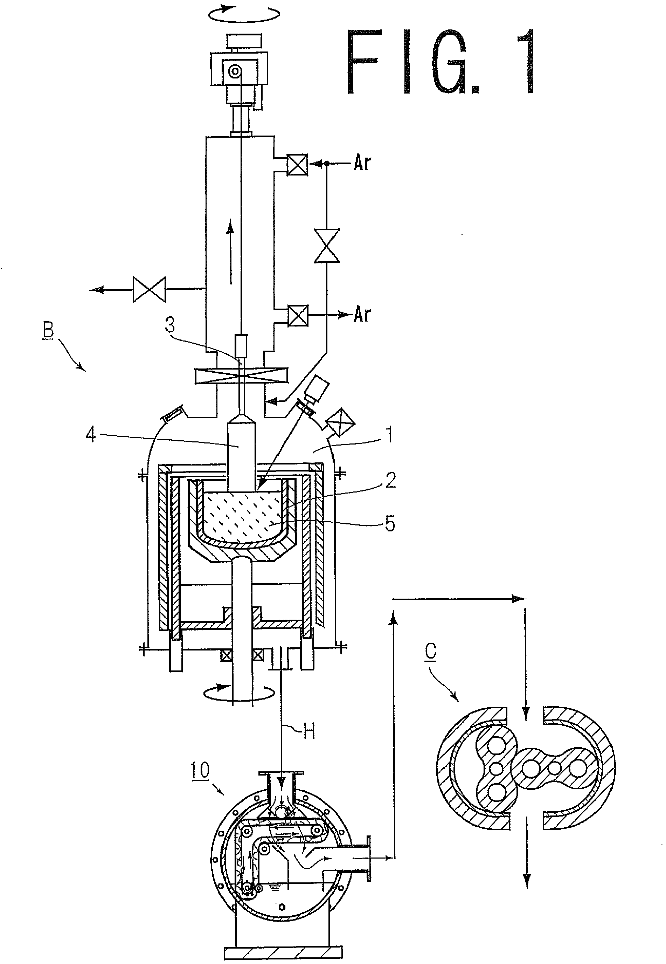

For example, as shown in Fig.1, the manufacturing equipment makes single crystals by CZ (Czochralski) method. Moltenpure Si, as rawmaterial of the single crystals, is accommodated in an SiO₂ crucible under a high-temperature atmosphere. A small amount of SiO microparticles generated by the reaction between the molten pure Si and SiO₂ of the crucible, a-Si microparticles, microparticles of reaction products, or the like is included in the exhaust gas. While the molten silicon exists inside a quartz crucible, the SiO is generated by reactions. A part of the SiO adheres to an inner wall of the crucible and the other part of the SiO is supplied to the vacuum pump with inert gas which is supplied into a furnace. The amount of the generated SiO relates to the frequency of the reaction. In general, a few hundred grams of the SiO is generated.

An oil-sealed rotary pump, a dry-vacuum pump, a mechanical booster pump, or the like can be used as the vacuum pump. Each vacuum pump has a sliding and contacting part between a rotor and a casing, or one rotor and the other rotor. The barely contained SiO powder enters into the sliding and contacting part, and wears the sliding and contacting part and forces the rotor into continuous overload rotation. Finally, the rotor is forced to stop. The stoppage of the rotor negatively affects manufacturing lines until recovery.

Therefore, Japanese Laid-Open Patent publication No. 9 -175881 (Patent Document 1) has been suggested. In the Patent Document 1, a technology for controlling "dust explosion" by moisturizing the exhaust gas that includes SiO and SiO2 is disclosed. The exhaust gas is moisturized by passing through a water reservoir arranged upstream of the dry vacuum pump (as a vacuum pump). Furthermore, a buffer tank and a vacuum breaking valve are provided upstream of the water reservoir. This avoids the vapour explosion in the single crystal manufacturing equipment caused by countercurrent flow of the water from the water reservoir into the equipment in case of emergency shutdown of the dry vacuum pump in trouble or blackout. According to the Patent Document 1, the issue in case of using the water reservoir canbe resolved. And the safeness and assuredness can be improved.

### Summary of the Invention

But the technology disclosed in the Patent Document 1 can not control the breakage of the dry vacuum pump. Because the exhaust gas in a state of bubble including the SiO and SiO₂ can pass through the water reservoir. Even if the dust explosion is controlled by moisturizing the SiO and SiO₂ almost the SiO and SiO₂ can not be removed efficiently.

Recently, a single crystal material for semiconductors is required to be a large diameter. And manufacturing equipment including the single crystal manufacturing equipment is required to be larger. Consequently, the stoppage of the manufacturing lines causes a serious damage to a company. This is not only for the above-mentioned single crystal manufacturing equipment but also for general manufacturing equipment, chemical equipment, and environmental equipment using reduced pressure.

The present inventionhas been made to clear the above issues associated with the conventional arts. It is, therefore, a main object of the present invention to provide a protective filter which can remove efficiently the microparticles, which causes the trouble of the vacuum pump, in the exhaust gas. And the protective filter can avoid the damage of the vacuum pump and prolong the life of the vacuum pump.

According to a first aspect of the present invention, a protecting filter (10) comprises:
a casing (12) having an inner space (19);
an exhaust gas intake pipe (14) guiding exhaust gas (H) with microparticles to the casing (12);
a rotating body (16) supported rotatably on the centre axis of the exhaust gas intake pipe (14) and at an opening of the exhaust gas intake pipe (14) inside the casing (12); and
an endless belt (18) provided rotatably inside the casing (12) and facing the opening of the exhaust gas intake pipe (14) across the rotating body (16) and including microparticle collection liquid (L) at least on its surface,
wherein, the surface of the endless belt (18) contacts the rotating body (16),
the rotating body (16) is rotated by rotation of the endless belt (18),
the microparticle collection liquid (L) on the surface of the endless belt (18) is applied to a surface of the rotating body (16).

The exhaust gas (H) including microparticles is guided into the casing (12) of the protective filter (10) through the exhaust gas intake pipe (14). The microparticles are mainly found on the centre axis (CL) of the exhaust gas intake pipe (14). The flow velocity of the exhaust gas (H) is fastest on the centre axis line (CL). The surface of the rotating body (16) wets with the microparticle collection liquid (L). Consequently, most of microparticles within the exhaust gas (H) hits and being collected on the surface of the rotating body (16).

Furthermore, the rotating body (16) is rotated by the rotation of the endless belt (18) which contacts the surface of the rotating body (16). And the microparticle collection liquid (L) on the surface of the endless belt (18) is being applied continuously to the surface of the rotating body (16). The microparticles hit against the surface of the rotating body (16) and being removed from the exhaust gas (H) by adsorption and collection to the microparticle collection liquid (L). The collected microparticles are rotated on the rotating body (16). Then the microparticles are wiped and moved to the surface of the endless belt (18). At the same time, new microparticle collection liquid (L) is applied to the surface of the rotating body (16) from the endless belt (18). And the new microparticle collection liquid (L) is rotated to the opening of the exhaust gas intake pipe (14). Consequently, the new microparticle collection liquid (L) adsorbs the microparticles in the exhaust gas (H) continuously.

As described, by rotating the rotating body (16) with the endless belt (18) including the microparticle collection liquid (L) on its surface, a series of procedure can be taken continuously. The series of procedure includes that "application of the microparticle collection liquid (L) to the surface of the rotating body (16)", "adsorption of the microparticles by the microparticle collection liquid (L)", "movement of the microparticle collection liquid (L) including the microparticles to the endless belt", and again "application of the microparticle collection liquid (L) ". Consequently, accumulation of the microparticles on a part of the surface of the rotating body (16) can be avoided.

And the exhaust gas (H) discharged into the casing (12) through the opening of the exhaust gas intake pipe (14) blows the endless belt (18) facing the opening. Most microparticles found on the centre axis line (CL) of the exhaust gas intake pipe (14) are adsorbed on the surface of the rotating body (16) arrangedon the centre axis line (CL). Furthermore, the microparticles, which are not adsorbed by the rotating body (16), found near an inner wall of the exhaust gas intake pipe (14) are adsorbed by the microparticle collection liquid (L) included on the surface of the endless belt (18), when the exhaust gas (H) passes through the endless belt (18).

The microparticle collection liquid (L) may be accumulated at the bottom of the casing (12).

And the protective filter (10) may further comprise a supply device (64) supplying the accumulated microparticle collection liquid (L) to the endless belt (18) or the rotating body (16).

Providing the supply device (64) makes the microparticle collection liquid (L), which is accumulatedat the bottomof the casing (12), reusable. Furthermore, the endless belt (18) can be provided separately from the accumulated microparticle collection liquid (L). Consequently, flexibility of filter (10) layout can be improved.

When the microparticle collection liquid (L) is accumulated at the bottom of the casing (12), a part of the endless belt (18) may be immersed into or be contacted with the accumulated microparticle collection liquid (L).

In this case, the microparticle collection liquid (L) on the surface of the endless belt (18) is supplied from a part of the endless belt (18) immersed into or contacted with the accumulated microparticle collection liquid (L) at the bottom of the casing (12). The supply device (64) or the like for supplying the microparticle collection liquid (L) to the endless belt (18) is not required. The configuration of the filter (10) can be simplified.

Furthermore, when a part of the endless belt (18) is immersed into or contacted with the accumulated microparticle collection liquid (L), the microparticles adsorbed and collected by the microparticle collection liquid (L) can be moved from the endless belt (18) to the accumulated microparticle collection liquid (L).

Consequently, newer microparticle collection liquid (L) including a small amount of the microparticles can be applied to the rotating body (16).

The microparticle collection liquid (L) may be high viscous and low vapour pressure liquid.

According to the protective filter of the present invention, the microparticles in the exhaust gas can be adsorbed and collected continuously in the long term without accumulation of the microparticles on a part of the surface of the rotating body. And the microparticles, which can not be adsorbed and collected by the rotating body, are adsorbed and collected by the endless belt. Consequently, the filtering efficiency of the microparticles can be improved. Accumulation and adhesion of the microparticles inside the vacuum pump can be prevented in the long term. Troubles caused by the microparticles can be fixed.

### Brief description of the Drawings

Fig.1 is a flow diagram of an embodiment of the present invention.
Fig.2 is a cross section of the protective filter of an embodiment of the present invention.
Fig.3 is a cross section taken along the line III-III of Fig.2.
Fig.4 is a cross section of another embodiment of the rotating body.
   Bottom part of the filer is not drawn.
Fig. 5 is a cross sectionof another embodiment of the protective filter.
Fig. 6 is a cross section of the other embodiment of the protective filter.

### Detailed Description

Embodiments of the present invention are explained with figures below. The embodiments are for manufacturing single crystal silicon for semiconductors from molten silicon liquid. The present invention is not limited to these embodiments. The present invention is applicable for cases that target equipment (B) is using reduced pressure and exhaust gas (H) including microparticles from the target equipment (B).

Fig.1 is a flow diagram showing an example that a vacuum pump (C) is provided with single crystal manufacturing equipment (B) using atmospheric method through a protective filter (10) of the present invention. A dry pump or an oil-sealed rotary pump can be provided in series downstream the vacuum pump (C). The case that pumps are connected in series is also called "a vacuum pump (C)".

The single crystal manufacturing equipment (B) shown in Fig.1 is lifting equipment for single crystal. These embodiments are explained with manufacturing single crystal silicon ingot as most popular material for semiconductor wafer.

High-purity polycrystal silicon and various dopant for different purposes are put into a melting crucible (2) which is made of quartz glass and is accommodated in a chamber (1), as shown in Fig. 1. The silicon and dopant are melted in Argon atmosphere. A single crystal (3) as a seed is dipped on a surface of molten silicon and is lifted slowly. Then the single crystal having the same preferred orientation that the seed single crystal (3) has is grown into a large column-shaped ingot (4).

In this process, inert argon gas is injected into the chamber (1) during growth of crystal. And the pressure inside the chamber (1) is reduced. Reaction products generated at a surface of molten liquid (5) is discharged. Then the inside of the chamber (1) is kept clean constantly. The pressure of the inside of the chamber (1) is controlled as 103 to 104 Pa (15 to 20 Torr), flowing Ar gas as carrier gas into the chamber (1). A small number of SiO microparticles or fume made of mainly microparticles generated from the molten liquid (5) can be discharged from the pressure controlled chamber (1). Consequently, the manufacturing ability for the single crystal ingot (4) can be improved dramatically. In other word, while the silicon is melting inside the quartz crucible, the exhaust gas (H) from the single crystal manufacturing equipment (B) includes a small number of SiO microparticles. SiO microparticles adhere and accumulate on an inner surface of exhaust system. Consequently, if the flaked or released SiO flows inside the vacuum pump (C) in operation, movable parts of the vacuum pump (C) suffer damages.

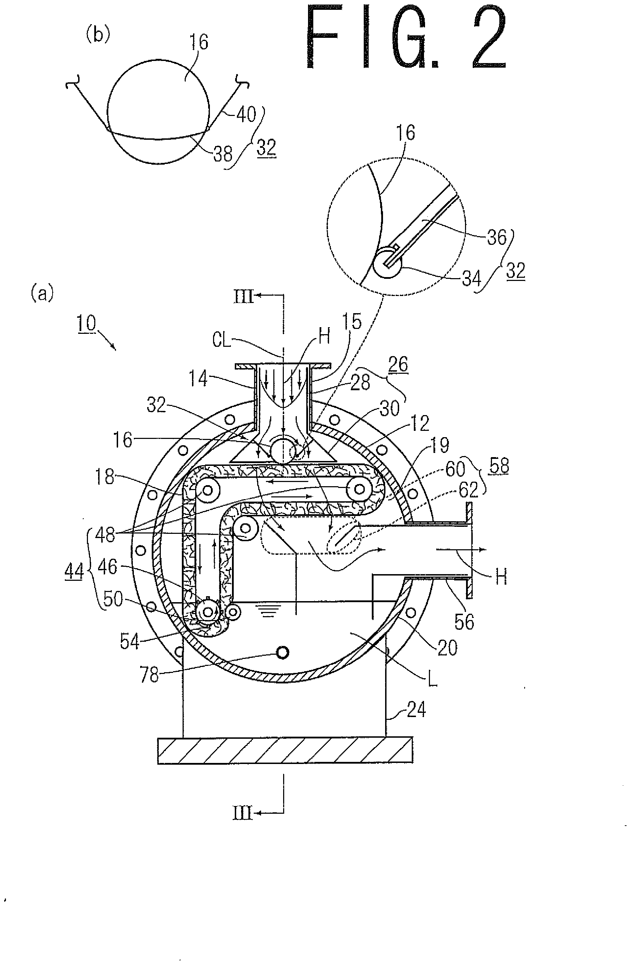

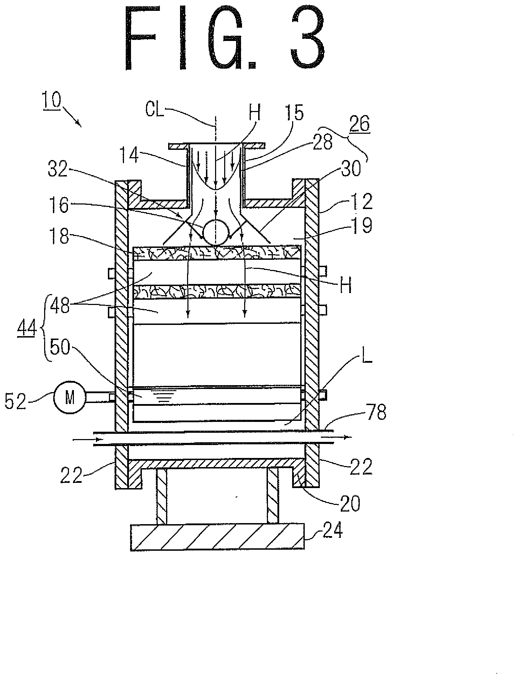

Embodiments of the protective filter (10) are shown in Fig.2 and Fig.3. The protective filter (10) comprises a casing (12), an exhaust gas intake pipe (14), a rotating body (16), an endless belt (18) adsorbing microparticles, and an exhaust gas discharge pipe (56).

The casing (12) has a sealed inner space (19). In this embodiment, the casing (12) has a cylindrical main body (20) having flanges at both ends, a pair of side boards (22) fixed on the flanges of the main body (20), and a base (24) supporting the main body (20). The configuration of the casing (12) is not limited to this embodiment.

And material for the casing (12) is not limited in the absence of corrosion by corrosion components in an exhaust gas (H) and microparticle collectionliquid (L) accumulated in the inner space (19). Corrosion-proof lining may be provided on surfaces facing the inner space (19).

Water may be used as the microparticle collection liquid (L). It is preferred to use high-viscosity and low vapour pressure oil such as fluorine series oil, silicon series oil, or mineral oil and plant-derived low vapour pressure oil such as glycerin as the microparticle collection liquid (L).

The high-viscosity and low vapour pressure liquid makes a thin film covering gaps between fibers of the endless belt (18), and the high-viscosity stringy liquid flows on the surface of the endless belt (18). Consequently, filtering efficiency is improved, because opportunity of gas-liquid contact becomes far higher, and adhesiveness of the microparticles becomes very high.

Furthermore, because the microparticle collection liquid (L) has low vapour pressure, vapour of the liquid (L) does not flow backward the equipment (B) operated under reduced pressure. Consequently, the equipment (B) will not be contaminated. "Dust explosion" or the like by chain of ignitions also be avoided, because the collected microparticles is wrapped in the high viscosity microparticle collection liquid (L).

Using glycerin gives little environmental impact, because supernatant liquid which SiO has settled out by water dilution can be treated as sewage.

In the protective filter (10) of this embodiment, the microparticle collection liquid (L) which has adsorbed the microparticles of SiO and SiO₂ up to Cp=about 15000 can be used. If the viscosity becomes higher than the limit, new liquid or regeneration waste can be changed to a part of the liquid (L). Then the operation can be continued. Coagulation method or centrifugation method can be applicable for regeneration.

The exhaust gas intake pipe (14) has a pipe part (15) guiding the exhaust gas (H) including the microparticles from outside [for example single crystal manufacturing equipment (B)] to the inner space (19) of the casing (12), and a lining (26) inserted at an end of the casing (12). In this embodiment, the exhaust gas intake pipe (14) is connected vertically and downwardly to the top of the main body (20) of the casing (12) with the flange. But the direction for insertion is not limited to the aforementioned direction.

The lining (26) is a part of the exhaust gas intake pipe (14) and comprises a cylindrical body (28) having a diameter which is smaller than inside diameter of the pipe part (15) of the exhaust gas intake pipe (14), and a hood (30) fixed at lower end of the cylindrical body (28). The cylindrical body (28) may be omitted, and the hood (30) may be connected directly to the pipe part (15) of the exhaust gas intake pipe (14).

Rotatingbodysupports (32) supporting the rotating body (16) rotatably on the centre axis line (CL) of the exhaust gas intake pipe (14) are provided inside the hood (30). In this embodiment, each rotating body support (32) comprises a disk-shaped roller (34) abutting to the rotating body (16), and a support (36) supporting the roller (34) rotatably. The support (36) has one end fixed to an inner surface of the hood (30) and the other end attached to the rotating roller (34). And the four rotating body supports (32) are arranged around the centre axis line (CL) in 90 degrees angular interval. The ball-shaped rotating body (16) is supported rotatably by the four rollers (34). Three ormore the rotatingbody supports (32) may be acceptable.

The rotating body support (32) is not limited to aforementioned embodiment. For example, the rotating body support (32) may be configured with a ring (38) having a diameter smaller than the diameter of the ball shaped rotating body (16), and a ring support (40) supporting the ring (38) on the centre axis line (CL) of the exhaust gas intake pipe (14) as shown in Fig.2 (b).

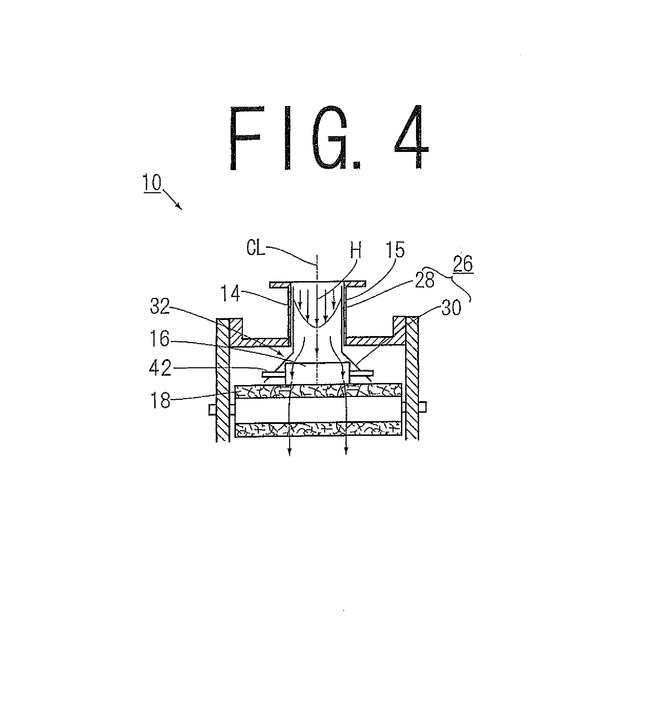

When a column shaped rotating body (16) is used, as described hereinafter (see Fig.4), an axis (42) bridged between one part of the inner surface of the hood (30) and the opposite part of the surface supports the rotating body (16) rotatably. In this case, the axis (42) is the rotating body support (32).

The rotating body (16), as previously explained, is a ball which is supported rotatably on the centre axis line (CL) of the exhaust gas intake pipe (14) at the opening of the exhaust gas intake pipe (14) in the casing (12). In this description, the meaning of "the opening" of the exhaust gas intake pipe (14) includes "near the opening". "Inside the pipe (14)" and "outside the pipe (14)" are also included in the meaning of "the opening". For example, in this embodiment, the rotating body (16) is arranged inside the hood (30). In other words, the rotating body (16) is arranged inside the exhaust gas intake pipe (14). Materials having corrosion resistance against corrosion components in the exhaust gas (H) and the microparticle collection liquid (L) accumulated in the inner space (19) may be used as well as the casing (12).

The endless belt (18) is provided inside the casing (12) and faces the opening of the exhaust gas intake pipe (14) through the rotating body (16). A surface of the endless belt (18) contacts the rotating body (16). And material having unwoven fabric part or mesh part of the endless belt (18) made by packing fibers of plastics or the like for keeping the microparticle collection liquid (L) at least on the surface is preferred to use as the endless belt (18). Such material has small airflow resistance and large specific surface area.

For example, the endless belt (18) can be formed with Saran Lock (registered) which is formed by saran fibers (registered) converted into unwoven fabric, coated and bundled with Saran latex. The surface of the endless belt (18) may be treated with surface modification. By changing surface energy ormolecularconfiguration,ormakingconcavesandconvexes on the surface of the fibers, wetting characteristics on the surface for the microparticle collection liquid (L) can be improved.

As described previously, the surface of the endless belt (18) contacts the rotating body (16). When the endless belt (18) drives, the rotating body (16) also rotates and the microparticle collection liquid (L) on the surface of the endless belt (18) is applied to the surface of the rotating body (16). If the rotating body (16) is hard to rotate on the slippy surface of the unwoven fabric or the mesh, it is preferred to provide a material having large friction resistance and large liquid content ratio (e. g. sponge) on the centre of width direction of the endless belt (18) where the rotating body (16) contacts. Such material may be put on the surface of the unwoven fabric. Alternatively, the unwoven fabric may be put into between the materials.

Mechanism for applying the microparticle collection liquid (L) on the surface of the rotation body (16) is explained below. The protective filter (10) has rotating machinery (44) for driving the endless belt (18). In this embodiment, the rotating machinery (44) has a drive axis (46), three driven axes (48), and a squeezing roller (50). These axes and roller are bridged horizontally between one side board (22) and the other side board (22) in the inner space (19) of the casing (12).

A motor (52) is connected to one end of the drive axis (46) directly or through gears, pulleys, or the like. The drive axis (46) received rotation force from the motor (52) rotates the endless belt (18). In addition, pins (54) are provided in an extended condition on the surface of the drive axis (46) contacting the endless belt (18). The pins (54) dig into back side of the endless belt (18). Consequently, slip of the drive axis (46) against the endless belt (18) is avoided. The "back side" of the endless belt (18) means opposite surface of the surface contacting the rotating body (16).

The drive axis (46) is arranged at a position lower than liquid surface of the microparticle collection liquid (L) accumulated at the inner bottom space of the casing (12). One driven axis (48) is provided at the first position that is on the upper side of the drive axis (46) and leads the endless belt (18) to contact the rotating body (16). Another driven axis (48) is provided at the second position that is on the same level of the first position and arranged across the centre axis line (CL) from the first position. The other one driven axis (48) is arranged at the third position that is between the first position and the second position and is lower than both positions.

Consequently, the endless belt (18) comprises a horizontal part including the surface contacting the rotating body (16) and a vertical part of which one end is immerged into the microparticle collection liquid (L). The horizontal part is a right-hand part shown in Fig.2, and the vertical part is a left-hand part shown in Fig.2. And the endless belt (18) has an L-shaped section. The lower end of the vertical part may be contacted to the liquid surface by adjusting the position of the drive axis (46) or level of the liquid surface. And a part of the horizontal part may be projected downward, and the projecting portion may be immerged or contacted to the microparticle collection liquid (L).

The squeezing roller (50) is arranged near a feeding side of the drive axis (46) and at the same level as the drive axis (46). The squeezing roller (50) is arranged at a position where a gap between a surface of the squeezing roller (50) and the drive axis (46) is narrower than a thickness of the endless belt (18). The "feeding side" of the drive axis (46) means an elevating side of the endless belt (18) from the surface of the microparticle collection liquid (L). In Fig.2, the feeding side is a right-hand part. Providing the squeezing roller (50) on the "feeding side" causes reduction of surplus microparticle collection liquid (L) included in the endless belt (18) through the microparticle collection liquid (L). Consequently, degree of impregnation is improved.

The exhaust gas discharge pipe (56) discharges the exhaust gas (H), from which the microparticles are removed, from the inner space (19) of the casing (12) to the downstream vacuum pump (C). In this embodiment, the exhaust gas discharge pipe (56) is connected horizontally to side of the main body (20) of the casing (12). A discharge guide (58) guiding the exhaust gas (H), from which the microparticles are removed, to the exhaust gas discharge pipe (56) is provided under the endless belt (18).

The discharge guide (58) is formed by combiningmetal or plastic boards. And the discharge guide (58) comprises: a funnel shape part (60) arranged just below the horizontal part of the endless belt (18) and having wide upper section; and a baffle part (62) changing flow of the exhaust gas (H) heading to the exhaust gas discharge pipe (56) downward, i.e. heading to the liquid surface.

The discharge guide (58) collects widely the exhaust gas (H), of which microparticles are removed on the surface of the endless belt (18) and the surface of the rotating body (16), by the funnel shape part (60). The microparticle collection liquid (L) for the endless belt (18) and the microparticles remaining in the exhaust gas (H) are removed by centrifugation. In this embodiment, the exhaust gas (H) being cleaner than a case that the discharge guide (58) is not provided is guided to the exhaust gas discharge pipe (56).

A procedure for removing the microparticles from the exhaust gas (H) by using the protective filter (10) of this embodiment is explained as below. Firstly, the motor (52) is started by turning on a switch (not shown) of the protective filter (10). The drive axis (46) and the endless belt (18) are rotated and driven by the motor (52). The microparticle collection liquid (L) is included into the surface of the endless belt (18) by one rotation of the endless belt (18). Then, the single crystal lifting equipment (B) and the vacuum pump (C) is started.

The exhaust gas (H) including the microparticles is flown into the casing (12) through the exhaust gas intake pipe (14) by starting the single crystal lifting equipment (B) and the vacuum pump (C). The microparticles are mainly found on the centre axis (CL) of the exhaust gas intake pipe (14). The flow velocity of the exhaust gas (H) is fastest on the centre axis (14). As explained above, the rotating body (16) is provided on the centre axis line (CL) of the exhaust gas intake pipe (14) and facing the opening of the exhaust gas intake pipe (14). And the rotating body (16) is supported rotatably by the rotating body support (32). Consequently, most microparticles in the exhaust gas (H) hit on the surface of the rotating body (16).

The rotating body (16) is rotated by the rotation of the endless belt (18) which contacts the surface of the rotating body (16). And the microparticle collection liquid (L) on the surface of the endless belt (18) is applied continuously to the surface of the rotating body (16). The microparticles hit the surface of the rotating body (16) and are removed from the exhaust gas (H) by adsorption and collection to the microparticle collection liquid (L). The collected microparticles are rotated on the rotating body (16) to the surface of the endless belt (18). Then the microparticles are wiped and moved to the surface of the endless belt (18). At the same time, new microparticle collection liquid (L) is applied to the surface of the rotating body (16) from the endless belt (18). And the new microparticle collection liquid (L) is rotated to the opening. Consequently, the new microparticle collection liquid (L) adsorbs the microparticles in the exhaust gas (H) continuously.

By rotating the rotating body (16) with the endless belt (18) including the microparticle collection liquid (L) on its surface, a series of procedure can be taken continuously. The series of procedure includes that "application of the microparticle collection liquid (L) to the surface of the rotating body (16)", "adsorption of the microparticles by the microparticle collection liquid (L)", "movement of the microparticle collection liquid (L) including the microparticles to the endless belt", and again "application of the microparticle collection liquid (L) ". Consequently, accumulation of the microparticles on a part of the surface of the rotating body (16) can be avoided.

And the exhaust gas (H) discharged into the casing (12) through the opening of the exhaust gas intake pipe (14) blows the endless belt (18) facing the opening. Most microparticles found on the centre axis line (CL) of the exhaust gas intake pipe (14) are adsorbed on the surface of the rotatingbody (16) arranged on the centre axis line (CL). Furthermore, the microparticles, which are not adsorbed by the rotating body (16), found near an inner wall of the exhaust gas intake pipe (14) are adsorbed by the microparticle collection liquid (L) included on the surface of the endless belt (18), when the exhaust gas (H) passes through the endless belt (18).

The exhaust gas (H), of which the microparticles are removed by passing through the endless belt (18), is collected by the funnel shape part (60) of the discharge guide (58) arranged under the horizontal part of the endless belt (18). The flow of the exhaust gas (H) is changed downward by the baffle (62). Then the exhaust gas (H) is guided to the vacuum pump (C) through the exhaust gas discharge pipe (56).

According to the protective filter (10) of this embodiment, the microparticles in the exhaust gas (H) can be adsorbed and collected continuously in the long term without accumulating the microparticles on a part of the surface of the rotating body (16). And the microparticles which can not be adsorbed and collected are adsorbed and collected by the endless belt (18). Consequently, the filtering efficiency of the microparticles can be improved. Accumulation and adhesion of the microparticles inside the vacuum pump (C) can be prevented in the long term. Troubles caused by the microparticles can be fixed.

In addition, a ball is used as the rotating body (16) in above mentioned embodiment. A column may be used as the rotating body (16) as shown in Fig.4. The centre axis of the columnar rotating body (16) may be arranged on the centre axis line (CL) of the exhaust gas intake pipe (14). In this case, an axis (42) supporting the columnar rotating body (16) rotatably between opposite inner surfaces of the hood (30) is the rotating body support (32).

And a cooling water pipe (78) for supplying cooling water to accumulated microparticle collection liquid (L) at the bottom of the casing may be provided. The cooling water avoids rise of temperature of the accumulated microparticle collection liquid (L) and undesirable evaporation of the liquid (L).

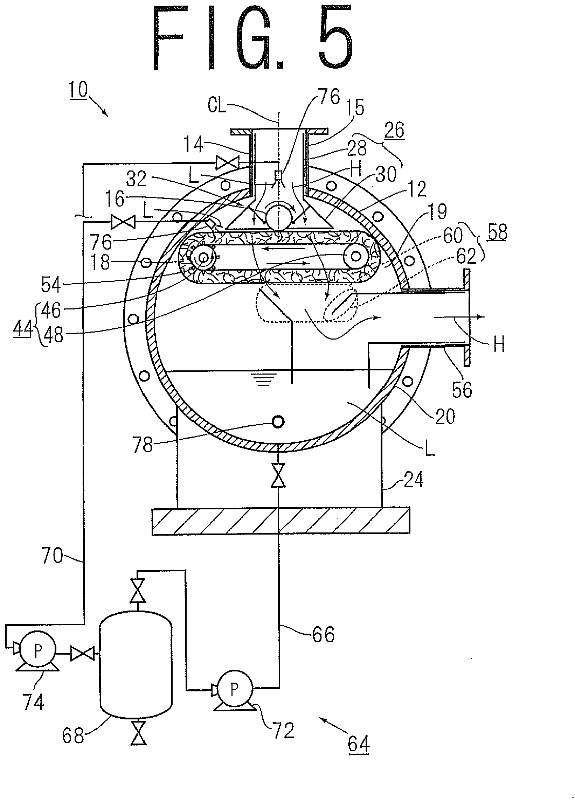

Furthermore, as shown in Fig.5, the non L-shaped endless belt (18) only having the horizontal part may be used. In this case, a supply device (64) supplying the accumulated microparticle collection liquid (L) to the highly-placed endless belt (18) and rotating body (16) is required.

The supply device (64) comprises a recovery pipe (66), a recovery tank (68), a supply pipe (70), a recovery pump (72), and a supply pump (74).

The recovery pipe (66) has one end connected to bottom of the casing (12), i.e. bottom of the main body (20), and the other end connected to the recovery tank (68). And some valves are provided on the recovery pipe (66). Other valves are provided on the supply pipe (70).

The recovery tank (68) accumulates temporarily the recovered microparticle collection liquid (L).

The supply pipe (70) has one end connected to bottom of the recovery tank (68) and the other end provided above the endless belt (18) or inside the exhaust gas intake pipe (14) at the inner space of the casing (12). And some valves are provided on the other end as required.

The recovery pump (72) is provided on the recovery pipe (86). And the recovery pump (72) supplies the microparticle collection liquid (L) accumulated at the bottom of the casing (12) to the recovery tank (68).

The supply pump (74) is provided on the supply pipe (70). And the supply pump (74) supplies the microparticle collection liquid (L) in the recovery tank (68) to the surface of the endless belt (18) or the rotating body (16).

According to this embodiment, the microparticle collection liquid (L) supplied by the supply device (64) adsorbs the microparticles on the surface of the rotating body (16) or the surface of the endless belt (18). Then the microparticle collection liquid (L) falls to the bottom of the casing (12) and is supplied into the casing again by the supply device (64).

The supply device (64) can be used for the protective filter (10) having the L-shaped endless belt (18) as shown in Fig.2 and Fig.3.

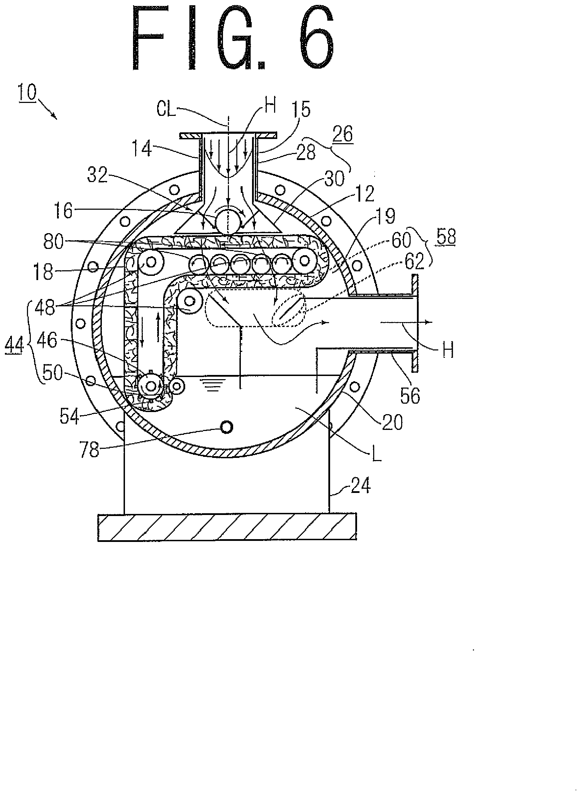

As shown in Fig. 6, some balls (80) may be provided on the lower belt of the horizontal part of the endless belt (18). Columnar rollers may also be used as the balls (80). The number of the balls (80) is not limited. But it is preferred to use as many balls as possible, because a large area of surface of the balls (80) improves the filtering efficiency of the microparticles in the exhaust gas (H).

The balls (80) contacting to the endless belt (18) rotate by drive of the endless belt (18). The balls (80) applied the microparticle collection liquid (L) collect the microparticles remaining in the exhaust gas (H) through the upper endless belt (18). Consequently, the filtering efficiency of the microparticles is improved.

## Claims

1. A protecting filter (10) comprising:
a casing (12) having an inner space (19);
an exhaust gas intake pipe (14) guiding exhaust gas (H) with microparticles to the casing (12);
a rotating body (16) supported rotatably on the centre axis of the exhaust gas intake pipe (14) and at an opening of the exhaust gas intake pipe (14) inside the casing (12); and
an endless belt (18) provided rotatably inside the casing (12) and facing the opening of the exhaust gas intake pipe (14) across the rotating body (16) and including microparticle collection liquid (L) at least on its surface,
wherein the surface of the endless belt (18) contacts the rotating body (16),
the rotating body (16) is rotated by rotation of the endless belt (18),
the microparticle collection liquid (L) on the surface of the endless belt (18) is applied to a surface of the rotating body (16).

2. A protective filter (10) according to claim 1, wherein
the microparticle collection liquid (L) is accumulated at the bottom of the casing (12), and
the protective filter (10) further comprise a supply device (64) supplying the accumulated microparticle collection liquid (L) to the endless belt (18) or the rotating body (16).

3. A protective filter (10) according to claim 1, wherein
the microparticle collection liquid (L) is accumulated at the bottom of the casing (12), and
a part of the endless belt (18) is immersed into or contacted with the accumulated microparticle collection liquid (L).

4. A protective filter (10) set forth in any one of claims 1 to 3, wherein
the microparticle collection liquid (L) is high viscous and low vapour pressure liquid.
